# EUROPEAN PATENT APPLICATION

(11) **EP 1 162 705 A2**
(43) Date of publication of application: **12.12.2001**
(21) Application number: 01106917.6
(22) Date of filing: 20.03.2001
(51) Int. Cl.: H01S 3/0941

(54) **High-power VIS solid-state laser**

(30) Priority: 09.06.2000 US 591205
(71) Applicant: Agilent Technologies, Inc. (a Delaware corporation), Palo Alto, CA 94303 (US)
(72) Inventor: Hasnain, Ghulam, Union City, California 94587 (US)
(74) Representative: Liesegang, Roland, Dr.-Ing.

(57) **Abstract**

The invention describes a laser capable of continuous wave operation at visible wavelengths. A diode laser lasing in the 340 to 640 nm wavelength range is used to pump a suitably doped solid state material within an optical cavity, which then emits visible light. Suitable solid state materials include ionic solids which are doped with rare earth ions. The solid state laser may be end-pumped or side-pumped.

## Description

### Field of the Invention

This invention relates to solid-state lasers, and more particularly to solid state lasers capable of emitting visible wavelengths.

### Background of the Invention

In many applications ranging from spectroscopy to medicine to reprographics, where high continuous wave (CW) power at visible wavelengths is needed, large ion-lasers (e.g. Ar⁺ and Kr⁺) are still dominant. Such lasers are extremely inefficient (<0.05% wall-plug efficiency) and require 3-phase electric supply and water cooling. In the past decade, diode-pumped solid-state lasers, which are efficient, compact and convenient to use, have begun to replace ion-lasers in many applications. The most common is the diode-pumped Nd-YAG (neodymium-yttrium aluminum garnet) laser, whose power output is limited to a few watts by that of the AlGaAs laser diodes used for optical pumping. Further, the Nd-YAG laser emits at an infrared wavelength of 1064 nm, but by using second-harmonic-generation (SHG) in a non-linear crystal such as KNbO₃ (typically in an intra-cavity configuration), visible green emission at 532 nm is obtained. However, the output power of such frequency-doubled solid-state visible lasers is greatly reduced because non-linear optical processes are generally inefficient.

### Summary of the Invention

This invention is a violet or near-UV pumped solid-state laser emitting directly in the blue to red range of the visible spectrum. This invention has been made possible only recently by the invention and demonstration of efficient, reliable and high power AlGaN/InGaN laser diodes that emit in the violet at a wavelength of about 410 nm (Nakamura, *et al., Applied Physics Letters,* **70(7):** 868-870; 1997). This invention therefore solves the problem of achieving a compact, efficient solid-state visible laser, in the blue, green, and yellow especially, by utilizing the high performance violet laser diode to optically pump a suitably doped crystal in a manner similar to conventional diode-pumped Nd-YAG lasers that emit in the infrared.

This invention includes, in one aspect, a diode pumped laser, comprising a power supply, at least one semiconductor diode laser capable of operating at a wavelength between 340 nm and 640 nm, and a suitably doped solid-state material within an optical cavity, wherein the solid-state material is in optical communication with the at least one diode laser. Stimulation of light emission from the laser diode(s) by the power supply results in emission of laser light with a wavelength between 400 and 700 nm from the solid-state material. Preferably, the laser diode comprises GaN and related ternary alloys AlGaN and InGaN and the quaternary alloy AlInGaN deposited epitaxially on a substrate. The active region preferably comprises InGaN quantum wells. The substrate may be GaN, SiC, sapphire, silicon or other crystal suitable for epitaxial growth of GaN and related alloys for fabricating the pump laser diodes.

This invention, in another aspect, is a method of generating stimulated emission of light with a wavelength between 400 and 700 nm. At least one laser diode capable of operating between wavelengths of 340 nm and 640 nm and a suitably doped solid-state material within an optical cavity and in optical communication with the laser diode(s) is provided. Means are also provided to generate stimulated emission of light by the laser diode(s). Emission of radiation by the laser diode causes stimulated emission of visible light by the solid-state material.

### Brief Description of the Drawing

Figure 1 is a diagram showing the energy levels of atoms in a laser.

Figure 2 is a schematic diagram of a diode laser in a solid state laser configured for end pumping.

Figure 3 is a schematic diagram of a diode laser array in a solid state laser configured for side pumping.

### Detailed Description

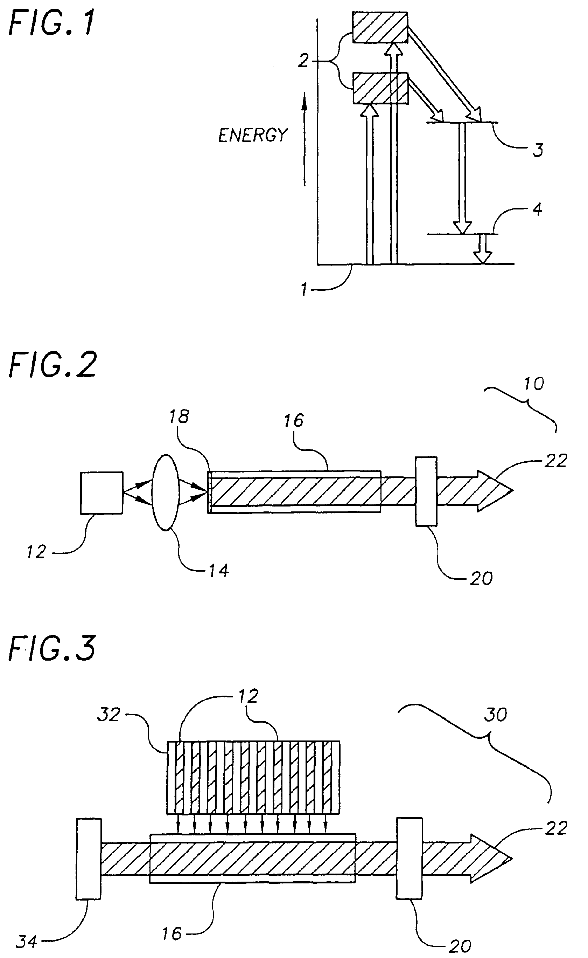

Figure 1 shows a diagram of the energy levels of the atoms in a laser. The atoms start at a ground state 1 and are excited to any of a plurality of higher states 2. They quickly decay to a metastable energy state 3. This metastable state 3 is the upper level for an energy transition which leads to the emission of laser light. The condition for emission is that there should be more atoms in this state than in the lower level of the transition 4, a condition called a population inversion. Unlike the transition shown in Figure 1, the lower level of the transition may correspond to the ground state 1. Otherwise, as shown in the figure, atoms decay from the lower energy state 4 to the ground state 1. If the population inversion can be maintained continuously, then the laser can emit in continuous-wave mode. If not, then the laser operates in pulsed mode. Other factors, such as the need to dissipate heat, may also require a laser to be operated in pulsed mode. Some continuous-wave lasers may also be operated in pulsed mode, depending on the application. The difference in energy between the upper level 3 and the lower level 4 determines the wavelength of the emitted light. That difference in energy depends in turn on available energy levels of the atoms. Therefore, given materials emit specific wavelengths. If there is no material which emits light of a given wavelength, a laser emitting that wavelength cannot be produced.

For example, the construction of a laser which continuously emits blue or green light has been a goal of the semiconductor industry for several years. A diode laser comprising AlGaN, GaN, and InGaN epitaxially grown on a sapphire substrate was recently developed which emits violet light at a wavelength of about 410 nm (Nakamura, *et al., Applied Physics Letters,* **70**(7): 868-870; 1997). To generate stimulated emission of blue or green light, one can increase the mole fraction of indium in the InGaN material in the laser-diode active region. However, too great a mole fraction of indium is detrimental to the materials properties of the active region, preventing laser operation. Thus, extending this laser diode material system to blue wavelengths (about 450nm) is already a significant challenge, and achieving a green laser using solely AlGaN and InGaN appears practically impossible at present. However, the violet laser diode discussed above can be used to pump other suitably doped solid state materials which can emit at the desired longer visible wavelengths.

Solid state lasers are those lasers in which the light-emitting atoms are part of a solid. They are distinguished from semiconductor lasers in that light emission is optically stimulated. Most solid state lasers comprise a non-conductive material doped with the light emitting atomic species. Semiconductor laser diodes are favored as optical "pumps" for solid state lasers because of their high electrical-to-optical power conversion efficiency. The laser diodes are chosen to emit light at a wavelength which is strongly absorbed by the dopant atoms in the solid state material. The excited atoms then emit light as described above. Materials and dopants can be selected to achieve desired emission wavelengths. For example, Nd-YAG (yttrium aluminum garnet) lasers emit at 1064 nm, but Nd-YLF (yttrium lithium fluoride) emits at 1047 nm and 1053 nm (Hecht, J. *Understanding Lasers.* New York: Institute of Electrical and Electronics Engineers, 1994. pp. 221-229).

For the solid state laser to emit at a given wavelength, the pumping diode must emit at a wavelength less than the desired lasing wavelength. Thus, the AlGaN/InGaN violet laserdiode discussed above can be very useful as part of a blue, green, or yellow laser in which it causes stimulated emission from a suitably doped solid state material. The construction of diode pumped solid state lasers is well known in the art (see, for example Brown, et al., *Applied Optics,* **36:** 8611-8633, 1997). A few exemplary configurations of the pumping diode and the solid state material are described below.

Figure 2 shows a solid state laser 10 in an end-pumping configuration. A diode laser 12 emits light which is focused in an optical system 14. The optical system comprises focusing optics such as lenses and apertures. Light then passes into a solid state rod of material 16 through a coating 18 which transmits light from the diode but reflects light at wavelengths emitted by the solid state material. The other end of the rod 16 is capped by a partially reflective mirror 20. Some laser light is reflected back into the rod 16 to continue stimulating further emission, increasing gain, and some light is transmitted to form an output beam 22. The doped solid state rod comprises an ionic solid doped with one or more rare earth ions. The ionic solid may be crystalline or aperiodic. Exemplary materials for the solid state rod include CaF doped with Ho³⁺ ions, LiYF₄ doped with Pr³⁺ ions, LiYF₄ doped with Tb³⁺ ions, LaF₃ doped with Pr³⁺ ions, and BaY₂F₈ doped with Er³⁺ ions(Kaminskii, A., *Laser Crystals - Their Physics and Properties.* Springer -Verlag Series in Optical Sciences, Vol. 14, Berlin: Springer-Verlag 1990).

Figure 3 depicts a solid state laser 30 in an side-pumping configuration. A diode array 32 comprising a plurality of diode lasers 12 emits light directly into the rod of solid state material 16. At one end of the rod 16 is a totally reflective mirror 34. At the other end is a partially reflective output mirror 20. As in the previous example, some laser light is reflected back into the rod and some is transmitted to form the output beam 22.

Other embodiments of the invention will be apparent to those skilled in the art from a consideration of the specification or practice of the invention disclosed herein. It is intended that the specification and examples be considered as exemplary only, with the true scope and spirit of the invention being indicated by the following claims.

## Claims

1. A diode pumped laser, comprising:
a power supply;
at least one laser diode capable of lasing at a wavelength between 340 nm and 640 nm; and
a doped solid-state material disposed within an optical cavity and in optical communication with the at least one laser diode;
wherein stimulation of light emission from the at least one laser diode by the power supply results in stimulated emission of light with a wavelength between 400 and 700 nm from the solid-state material.

2. The laser of claim 1, wherein the laser diode comprises a plurality of layers deposited on a substrate, and wherein each layer comprises a material from the group consisting of AlGaN, GaN, InGaN, and AlInGaN.

3. The laser of claim 2, wherein the substrate comprises a material from the group consisting of GaN, SiC, silicon, or sapphire.

4. The laser of one of the preceding claims, wherein the doped solid state material comprises an ionic solid doped with one or more rare-earth ions.

5. The laser of claim 4, wherein the doped ionic solid comprises a material from the group consisting of CaF doped with Ho³⁺ ions, LiYF₄ doped with Pr³⁺ ions, LiYF₄ doped with Tb³⁺ ions, LaF₃ doped with Pr³⁺ ions, and BaY₂F₈ doped with Er³⁺ ions.

6. A method of generating stimulated emission of light with a wavelength between 400 and 700 nm, comprising:
providing at least one laser diode capable of emitting electromagnetic radiation between wavelengths of 340 nm and 640 nm;
providing a doped solid-state material within an optical cavity and in optical communication with the at least one laser diode; and
providing means to generate stimulated emission of light by the at least one laser diode;
wherein emission of radiation by the laser diode causes stimulated emission of visible light by the solid-state material.

7. The method of claim 6, wherein the laser diode comprises a plurality of layers deposited on a substrate, and wherein each layer comprises a material from the group consisting of AlGaN, GaN, InGaN, and AlInGaN.

8. The method of claim 7, wherein the substrate comprises a material from the group consisting of GaN, SiC, silicon or sapphire.

9. The method of one of claims 6 to 8, wherein the doped solid state material comprises an ionic solid doped with one or more rare earth ions.

10. The method of claim 9, wherein the doped ionic solid comprises a material from the group consisting of CaF doped with Ho³⁺ ions, LiYF₄ doped with Pr³⁺ ions, LiYF₄ doped with Tb³⁺ ions, LaF₃ doped with Pr³⁺ ions and BaY₂F₈ doped with Er³⁺ ions.
